# EUROPEAN PATENT APPLICATION

(11) **EP 2 837 711 A1**
(43) Date of publication of application: **18.02.2015**
(21) Application number: 13183105.9
(22) Date of filing: 05.09.2013
(51) Int. Cl.: C23C 16/455, C23C 16/458

(54) **Chemical vapor deposition device**

(30) Priority: 15.08.2013 US 201313968328
(71) Applicant: Samsung SDI Co., Ltd., Yongin-si, Gyeonggi-do (KR)
(72) Inventor: Kim, Woo-Jin, Gyeonggi-do (KR)
(74) Representative: Taor, Simon Edward William

(57) **Abstract**

There is provided a chemical vapor deposition device (100, 200, 300) comprising: a support member (120, 220, 320) arranged to support a first surface of a substrate; a deposition head (160, 260, 360) arranged to supply deposition gas towards a second surface of the substrate, the second surface of the substrate being an opposite surface to the first surface of the substrate; a frame arranged around an edge portion of the support member (120, 220, 320), the frame having a purge gas supply port (131, 231, 331) arranged to supply purge gas from a location on a side of the substrate opposite to the deposition head (160, 260, 360), and at least one exhaust port (132, 232, 332) arranged around an edge portion of the support member (120, 220, 320); and a chamber (110, 210, 310) arranged to house the support member (120, 220, 320), deposition head (160, 260, 360), and the frame.

## Description

The present invention relates to a device, and more particularly, to a chemical vapor deposition device.

Generally, a chemical vapor deposition device may be used in depositing various substrates. For example, the chemical vapor deposition device may be used in depositing a substrate that is necessary when manufacturing a solar cell or in depositing a substrate that is necessary when manufacturing a display panel. Such a chemical vapor deposition device may deposit a substrate by spraying deposition gas on the upper side. The purge gas may be sprayed from the lower side of the substrate to prevent deposition of the deposition gas on the lower surface of the substrate or non-uniform deposition of the deposition gas on the side surface.

The supplied purge gas may be moved from the lower surface of the substrate to the upper surface of the substrate. Furthermore, the deposition of the substrate may not be appropriately performed due to the movement of the structure that fixes or supports the substrate by being stored in the edge area of the substrate. Hence, it is necessary to smoothly exhaust the purge gas to improve the deposition uniformity of the substrate edge area.

The present general inventive concept provides a chemical vapour deposition device for improving film uniformity at an edge portion of a substrate.

According to an aspect of the invention, there is provided a chemical vapor deposition device comprising: a support member arranged to support a first surface of a substrate; a deposition head arranged to supply deposition gas towards a second surface of the substrate, the second surface of the substrate being an opposite surface to the first surface of the substrate; a frame arranged around an edge portion of the support member, the frame having a purge gas supply port arranged to supply purge gas from a location on a side of the substrate opposite to the deposition head, and at least one exhaust port arranged around an edge portion of the support member; and a chamber arranged to house the support member, deposition head, and the frame.

In some embodiments, the frame comprises a jacket arranged around the edge portion of the support member.

In some embodiments, the jacket is arranged to cover a portion of the first surface of the substrate.

In some embodiments, the frame comprises a shadow frame arranged around an edge portion of the support member so as to cover a portion of the second surface of the substrate.

In some embodiments, a portion of the jacket is arranged to support the shadow frame.

In some embodiments, the deposition gas is arranged to flow from the deposition head to the second surface of substrate; and wherein the purge gas is arranged to flow towards the deposition head, and then towards a said exhaust port.

In some embodiments, the purge gas is arranged to flow from the purge gas supply port to the first surface of the substrate, between the first surface of the substrate and a portion of the jacket, and then towards a said exhaust port.

In some embodiments, the jacket comprises the each exhaust port.

In some embodiments, the purge gas supply port comprises a hole extending though a portion of the jacket.

In some embodiments, at least one said exhaust port is formed as a hole extending from a portion of the hole forming the purge gas supply port to an external portion of the jacket.

In some embodiments, the each exhaust port is located between the jacket and the shadow frame.

In some embodiments, the jacket comprises a purge gas supply unit coupled with the purge gas supply port; and a jacket body coupled to the purge gas supply unit.

In some embodiments, the chemical vapour deposition device further comprises an exhaust unit coupled to the chamber, and the exhaust unit arranged to remove exhaust deposition gas and exhaust purge gas from the chamber (210, 310).

In some embodiments, the exhaust unit is located proximate a said exhaust port.

In some embodiments, the exhaust unit comprises: a suction pipe coupled to the chamber; and a vacuum pump coupled to the suction pipe.

In some embodiments, a dimension of the exhaust port is from between 20% to 75% of a thickness of the frame.

In some embodiments, the frame comprises a plurality exhaust ports, and wherein the ratio of a width of a said exhaust port to a shortest distance between two said exhaust ports is from 0.25 to 4.

According to the present invention, the deposition uniformity may be improved by preventing the purge gas from moving to the upper surface of the substrate or being stored in the edge area of the substrate. Furthermore, according to the present invention, a smooth exhaust of the purge gas may be promoted by discharging the purge gas to the side of the jacket.
FIG. 1 is a conceptual diagram illustrating a chemical vapor deposition device according to an exemplary embodiment of the present invention.
FIG. 2 is an enlarged conceptual diagram of A portion of FIG. 1.
FIG. 3 is a diagram illustrating a side surface of a jacket and a show frame of FIG. 2.
FIG. 4 is a conceptual diagram illustrating a chemical vapor deposition device according to another exemplary embodiment of the present invention.
FIG. 5 is an enlarged conceptual diagram of B portion of FIG. 4.
FIG. 6 is a diagram illustrating a side surface of a jacket and a shadow frame of FIG. 5.
FIG. 7 is a conceptual diagram illustrating a chemical vapor deposition device according to another exemplary embodiment of the present invention.
FIG. 8 is an enlarged conceptual diagram of C portion of FIG. 7.

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. Like reference numerals in the drawings denote like elements, and thus their description will be omitted. Terms such as "including," "having," "consist of" may be intended to indicate a plurality of components unless the terms are used with the term "~only." Terms such as "first" and "second" may be used to describe various components, but the invention is not limited by such terms. The terms are used only to distinguish one component from another.

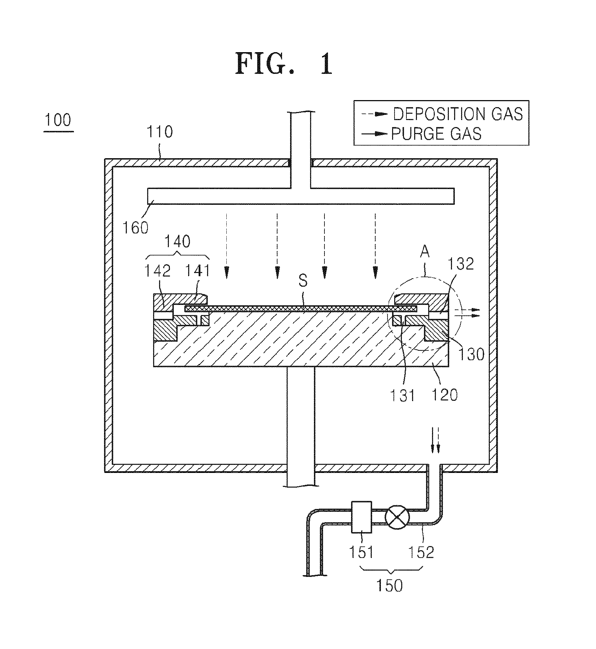

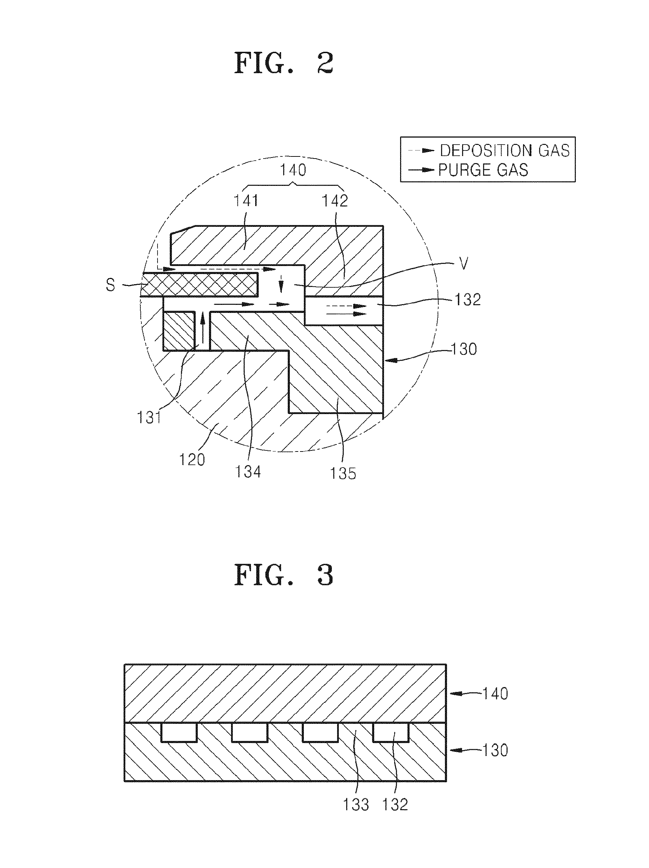

FIG. 1 is a conceptual diagram illustrating a chemical vapor deposition device 100 according to an exemplary embodiment of the present invention. FIG. 2 is an enlarged conceptual diagram of A portion of FIG. 1. FIG. 3 is a diagram illustrating a side surface of a jacket 130 and a shadow frame 140 of FIG. 2.

Referring to FIGS. 1 to 3, the chemical vapor deposition device 100 may include a chamber 100 in which a space is formed. Further, the chemical vapor deposition device 100 may include a support member 120 for placing the substrate S. A heater (not shown) may be installed to apply heat to the placed substrate S.

Furthermore, the chemical vapor deposition device 100 is installed to cover the external part of the support member 120, and may include a jacket 130 where a purge gas supply hole 131 for supplying the purge gas to the substrate S is formed. A part of the external side of the jacket 130 may form a purge gas supply hole 131 by being placed away from a part of the external side of the support member 120 by a certain distance. Furthermore, the purge gas supply hole 131 may be formed to penetrate the inside of the jacket 130 from the bottom upwards. However, the description below will center on the case where the purge gas supply hole 131 is formed inside the jacket 130 for the convenience of explanation.

The above purge gas supply hole 131 may be connected to a purge gas supply line (not shown). The purge gas supply line may be bent along the internal side of the supporting member 120, and may be connected to the outside through a part of the supporting member 120. The purge gas supply hole 131 provides a purge gas supply port.

Furthermore, the jacket 130 may include a purge gas supply unit 134 where the purge gas supply hole 131 is formed, and a jacket body unit 135 connected to the purge gas supply unit 134, at least whose part supports the shadow frame 140.

In some embodiments, the jacket 130 and the shadow frame 140 comprise a frame arranged around an edge portion of the support member, the frame having the purge gas supply port. The purge gas supply port is arranged to supply purge gas from a location on a side of the substrate opposite to the deposition head towards the surface of the substrate that is supported by the support member. The frame also comprises at least one exhaust port arranged around an edge portion of the support member.

The above jacket 130 may be formed in a multi-stepped manner. In detail, the thickness of the purge gas supply unit 134 may be set to be different from the thickness of the jacket body unit 135. In particular, the thickness of the purge gas supply unit 134 may be formed smaller than the thickness of the jacket body unit 135.

Furthermore, the jacket 130 may include an exhaust unit 132 that exhausts part of the purge gas, which is supplied from the purge gas supply hole 131 to the substrate S, to the outside. The exhaust unit 132 may be formed in various positions of the jacket 130 in the direction of the external side of the jacket 130 from the supporting member 120 as described above. The exhaust unit 132 acts as an exhaust port.

Furthermore, the exhaust unit 132 may be formed at various positions. For example, the exhaust unit 132 may be formed at the external side of the jacket 130. In particular, the exhaust unit 132 may be formed at the external side of the jacket body unit 135 where the shadow frame 140 contacts the jacket 130. Furthermore, the exhaust unit 132 may be formed in a hole form to penetrate the inside of the jacket 130. However, hereinafter, the description will center on the case in which the exhaust unit 132 is formed at the external side of the jacket body unit 135 for the convenience of the explanation.

The exhaust gas may be exhausted in downward direction from the external side of the jacket body unit 135 that contacts the shadow frame 140. Further, the exhaust unit 132 may be extended in a longitudinal direction of the jacket 130.

In particular, the exhaust unit 132 may be formed to be connected to a space V formed by the upper side of the purge gas supply unit 134, the border of the substrate S and the lower side of the shadow frame 140.

Furthermore, a plurality of exhaust units 132 may be provided. The plurality of exhaust units 132 may be formed at regular intervals. In particular, as described above, if there are a plurality of exhaust units 132, the jacket 130 may be formed to be placed adjacent to the exhaust unit 132 so as to include the support unit 133 that supports a part of the shadow frame 140.

A plurality of exhaust units 132 may be placed in various forms with a plurality of purge gas supply holes 131. For example, each exhaust unit 132 and each purge gas supply hole 131 may be placed along one straight line. Each exhaust unit 132 may be formed only on the jacket body unit 135 so that each exhaust unit 132 may not be connected to the purge gas supply hole 131. Further, each exhaust unit 132 may be formed on the external side of the purge gas supply unit 134 and the jacket body unit 135 so as to be connected to each purge gas supply hole 131. Further, each exhaust unit 132 and each purge gas supply hole 131 may be alternately formed. Each exhaust unit 132 may be formed on only the jacket body unit 135. However, the description below will center on the case where each exhaust unit 132 and each purge gas supply hole 131 may be alternately formed for the convenience of explanation.

The exhaust unit 132 and the support unit 133 may be formed to have different heights. For example, the height of the exhaust unit 132 may be smaller than the height of the support unit 133. In particular, the exhaust unit 132 may be inserted from the external surface of the jacket body unit 135 and be formed, and the support unit 133 may be projected from the external surface of the jacket body unit 135 and be formed, or may be formed in a manner that is the same as that of the external surface of the jacket body unit 135. That is, the exhaust unit 132 and the support unit 133 may be alternately formed or be formed with a certain ratio so as to form an uneven structure.

The ratio of the exhaust unit 132 to the width of the support unit 133 between adjacent exhaust units 132 may be 4:1 or 1:4. For example, if the width of the exhaust unit 132 is 4, the width of the support unit 133 between adjacent exhaust units 132 may be 1, and if the width of the exhaust unit 132 is 1, the width of the support unit 133 between adjacent exhaust units 132 may be 4.

In particular, when the width of the exhaust unit 132 exceeds four times of the width of the supporting unit 133 between adjacent exhaust units 132, the supporting unit 133 may be deformed so that the supporting unit 133 may fail to support the shadow frame 140 or the position of the shadow frame 140 may be deviated.

In contrast, if the width of the exhaust unit 132 is less than 1/4 of the width of the supporting unit 133 between adjacent exhaust units 132, the size of the exhaust unit 132 may be too small to smoothly exhaust the deposition gas or purge gas.

Further, the depth or diameter (i.e. the dimension) of the exhaust units 132 may be between about 20% and about 75% of the thickness of the jacket 130 (or in some embodiments 20% to 70%). If the depth or diameter of the exhaust unit 132 is less than 20% of the thickness of the jacket 130, the purge gas and deposition gas may be not smoothly discharged so that the deposition uniformity of the substrate S may not be secured. Further, if the depth or diameter of the exhaust unit 132 exceeds 75% of the thickness of the jacket 130, the jacket 130 may not effectively support the shadow frame 140 so that the position of the shadow frame 140 may be deviated or the substrate S may be broken.

Furthermore, the chemical vapor deposition device 100 may installed to contact the jacket 130, and may include a shadow frame 130, at least part of which may be placed on the upper surface of the substrate S. The shadow frame 140 may include a fixing unit 141 placed on the upper surface of the substrate S. Further, the shadow frame 140 may include a contact unit 142 which is bent from the fixing unit 141 and is formed. The contact unit 142 may be placed from the border of the substrate S at regular intervals, and may contact one surface of the jacket 130. In particular, the exhaust unit 132 may be connected to a space V formed by the upper side of the purge gas supply unit 134, the border of the substrate S and the lower side of the shadow frame 140, and may exhaust the purge gas to the outside.

The chemical vapor deposition device 100 may be installed inside the chamber 110, and may include a shower head 160 (i.e. a deposition head) that sprays the deposition gas to the substrate S. The shower head 160 may be supplied the deposition gas from the outside and may spray the gas to the substrate S.

Further, the chemical vapor deposition device 100 may insert the substrate into the inside of the chamber 110, and safely place the substrate S on the support member 120. The shadow frame 140 may be placed in a state placed away from the substrate S at regular intervals.

If the substrate S is placed as described above, the support member 120 is raised up so that the substrate S may be set to contact the shadow frame 140. Specifically, the substrate S may be fixed by placing the fixing unit 141 on the upper surface of the substrate S to contact the substrate S.

If the above process is completed, the purge gas is supplied to the substrate S through the shower head 160, and the purge gas may be supplied from the lower surface of the substrate S through the purge gas supply hole 131 of the substrate S. In particular, the purge gas may be externally supplied to the purge gas supply hole 131 through the purge gas supply line. The diethylzinc (DEZ) and vapor (H₂O) may be used as the deposition gas, and Argon (Ar) may be used as the purge gas. However, the deposition gas and the purge gas of the embodiments of the present invention are merely examples, and the deposition gas and the purge gas used in the chemical vapor deposition method may be included.

Likewise, if the deposition gas and the purge gas are respectively supplied, the purge gas may prevent the deposition gas from flowing into the lower surface of the substrate S. Specifically, the deposition gas may flow from the central part of the substrate S to the border part, and may be inserted into a space between the substrate S and the fixing unit 141. In particular, the deposition gas may flow into the space V formed by the upper side of the purge gas supply unit 134, the border of the substrate S and the lower side of the shadow frame 140. Further, the purge gas may flow to the space between the lower surface of the substrate S and the upper surface of the jacket 130 through the purge gas supply hole 131. The purge gas may flow into the space V formed by the upper side of the purge gas supply unit 134, the border of the substrate S and the lower side of the shadow frame 140.

In particular, the deposition gas and the purge gas are balanced according to the mutual pressure, and the deposition gas may maintain the state stored in the space V formed by the upper side of the purge gas supply unit 134, the border of the substrate S and the lower side of the shadow frame 140. The non-uniform deposition may be performed as the concentration of the deposition gas is increased on the border of the substrate S by the deposition gas stored in the space V formed by the upper side of the purge gas supply unit 134, the border of the substrate S and the lower side of the shadow frame 140.

Further, if the pressure of the deposition gas is smaller than the pressure of the purge gas, the purge gas may be discharged to the inside of the chamber 110 through the space between the shadow frame 140 and the substrate S from space V formed by the upper side of the purge gas supply unit 134, the border of the substrate S and the lower side of the shadow frame 140. As explained above, the deposition of the border area of the substrate S may become uneven by preventing the deposition of the border portion of the substrate S. In particular, the shadow frame 140 may be moved by the pressure of the purge gas.

However, in the case of the chemical vapor deposition device 100 according to embodiments of the present invention, the problem may be resolved by discharging the purge gas to the outside through the exhaust unit 132, the uneven deposition of the border portion of the substrate S is prevented.

Specifically, a part of the purge gas supplied through the purge gas supply hole 131 may be discharged to the chamber 110 side through the exhaust unit 132. For example, as described above, the exhaust unit 132 may discharge the purge gas to the outside of the jacket 130 by connecting the space V formed by the upper side of the purge gas supply unit 134, the border of the substrate S and the lower side of the shadow frame 140 and the border of the substrate S to the outside of the jacket 130.

Likewise, the exhaust unit 132 is connected to at least one of space V formed by the upper side of the purge gas supply unit 134, the border of the substrate S and the lower side of the shadow frame 140, and the purge gas supply hole 131, and may guide the purge gas to the outside of the jacket 130. Further, the exhaust unit 132 may discharge a part of the deposition gas to the outside of the jacket 130.

Likewise, when discharged, the purge gas does not flow into the space V between the substrate S and the fixing unit 141, and the deposition gas does not need to flow to the lower surface of the substrate S. Further, the deposition gas uniformity of the border area of the substrate S may be maintained constant.

In particular, in the above case, the case where the exhaust unit 132 is not provided and the case where the exhaust unit 132 is provided are shown in the comparative example and the experimental example below. T denotes the thickness of the deposited film, and the unit is micrometer (µm). Rs denotes the resistance of the deposited film, and the unit is Ω /sq. Further, the horizontal and vertical numbers denote the x-coordinate and y-coordinate of the substrate S. In particular, % value indicates the relation between the maximum value and the minimum value among the data, and may be acquired by (maximum value - minimum value)/(maximum value + minimum value) multiplied by 100.

### <Comparative Example>

| T(*µ*m) | 8.2% | | | | |
|---|---|---|---|---|---|
| | 15 | 125 | 235 | 345 | 455 |
| 355 | 1.1736 | 1.1378 | 1.0665 | 1.0914 | 1.1104 |
| 270 | 1.1831 | 1.1378 | 1.1356 | 1.0996 | 1.1481 |
| 185 | 1.1514 | 1.2469 | 1.2561 | 1.2346 | 1.1384 |
| 100 | 1.1518 | 1.1253 | 1.1112 | 1.1822 | 1.1393 |
| 15 | 1.1401 | 1.1957 | 1.0996 | 1.1321 | 1.1377 |
| | | | | | |

| Rs(Ω /sq) | 20.7% | | | | |
|---|---|---|---|---|---|
| | 15 | 125 | 235 | 345 | 455 |
| 355 | 13.65 | 16.6 | 17.4 | 16.8 | 14.9 |
| 270 | 12.606 | 13.12 | 14.54 | 14.33 | 13.32 |
| 185 | 13.33 | 13.54 | 16.17 | 15.65 | 13.68 |
| 100 | 12.7 | 14.92 | 17.21 | 16.65 | 13.62 |
| 15 | 13.24 | 15.26 | 19.2 | 17.39 | 15.25 |
| | | | | | |

| <Experimental Example > | | | | | |
|---|---|---|---|---|---|
| T(*µ*m) | 3.7% | | | | |
| | 15 | 125 | 235 | 345 | 455 |
| 355 | 1.179 | 1.2307 | 1.16 | 1.1833 | 1.1843 |
| 270 | 1.1548 | 1.2296 | 1.1602 | 1.1918 | 1.1952 |
| 185 | 1.1847 | 1.2165 | 1.1427 | 1.171 | 1.1647 |
| 100 | 1.1873 | 1.1894 | 1.1481 | 1.1807 | 1.1721 |
| 15 | 1.184 | 1.1786 | 1.1662 | 1.195 | 1.1627 |
| | | | | | |

| Rs(Ω /sq) | 9.8% | | | | |
|---|---|---|---|---|---|
| | 15 | 125 | 235 | 345 | 455 |
| 355 | 13.55 | 12.63 | 13.75 | 13.78 | 13.54 |
| 270 | 12.496 | 12.8 | 14.28 | 13.61 | 12.82 |
| 185 | 12.79 | 13.55 | 15.21 | 15.07 | 13.64 |
| 100 | 12.95 | 13.96 | 14.99 | 14.59 | 13.42 |
| 15 | 13.18 | 13.2 | 15.22 | 13.47 | 13.62 |

As shown above, the uniformity of the thickness of the deposited film has been improved from 8.2% to 3.7%, which shows that the difference between the minimum value and the maximum value has been reduced, and the thickness according to each coordinate has become similar. Further, the uniformity of the resistance of the deposited film according to each coordinate has been improved from 20.7% to 9.8%. In particular, it is shown that the uniformity of the deposited film is improved as the thickness of the deposited film becomes uniform throughout the entire substrate S. Hence, the chemical vapor deposition device 100 may improve the deposition uniformity of the substrate S by preventing the purge gas from being moved to the upper surface of the substrate S or being stored in the border area of the substrate S by exhausting the purge gas to the side of the jacket 130. Further, the chemical vapor deposition device 100 may promote smooth exhaustion of the purge gas by exhausting the purge gas to the side of the jacket 130. Further, the chemical vapor deposition device 100 may promote the smooth discharge of the purge gas by discharging the purge gas to the side of the jacket 130.

The chemical vapor deposition device 100 may include an exhaust unit 150 that is installed in the chamber 110, sucks the gas inside the chamber 110, and discharges the gas to the outside. In some embodiments, the suction unit 150 may include a suction pipe 152 installed at a bottom surface of the chamber 110 and a vacuum pump 151 installed in the suction pipe 152. Alternatively, the suction unit 150, including the suction pipe 152 and vacuum pump 151, may be installed at a side surface of the chamber 110. In some embodiments, the purge gas is discharged through the exhaust unit 132 as a result of the pressure difference between the space V and the inside of the chamber 110 when the suction pipe 152 of the suction unit 150 operates.

In particular, the chemical vapor deposition device 100 may exhaust the deposition gas, which has flowed into the border area of the substrate S along the space between the space V and the shadow frame 140, to the side of the jacket 130 along the exhaust unit 132 along with the purge gas, so that the purge gas is prevented from being moved to the upper surface of the substrate S and from reaching the lower surface of the substrate where the deposition gas contacts the supporting member 120.

In the above embodiment, the jacket 130 and the shadow frame 140 provide a frame having a purge gas supply port arranged to supply purge gas from a location on a side of the substrate opposite to the deposition head 160 towards the surface of a substrate supported by the support member 120, and at least one exhaust port 132 arranged around an edge portion of the support member 120.

In the above embodiment, the frame comprises the jacket 130 arranged around an the edge portion of the support member 120, with the jacket 130 arranged to cover a portion of the first surface of the substrate. The frame also comprises a shadow frame 140 arranged around an edge portion of the support member 120so as to cover a portion of the second surface of the substrate. A portion of the jacket 130 is arranged to support the shadow frame 140.

In the above embodiment, the deposition gas is arranged to flow from the deposition head 160 to the second surface of substrate, between the second surface of the substrate and a portion of the shadow frame 140, and then towards an exhaust port 132. In addition, the purge gas is arranged to flow from the purge gas supply port 131 to the first surface of the substrate, between the first surface of the substrate and a portion of the jacket 130 towards the deposition head, and then towards an exhaust port 132.

Furthermore, the purge gas is arranged to flow from the purge gas supply port 131 to the first surface of the substrate, between the first surface of the substrate and a portion of the jacket 130, and then towards an exhaust port 132. In some embodiments, the jacket comprises each exhaust port.

In the above embodiment, the purge gas supply port 131 comprises a hole extending though a portion of the jacket 130, and the exhaust ports 132 are located between the jacket 130 and the shadow frame 140.

In some embodiments, a dimension (e.g. the diameter, if circular) of the exhaust port 132 is from between 20% to 75% of a thickness of the frame (e.g. the corresponding portion of the jacket).

In some embodiments, the frame comprises a plurality of exhaust ports 132, and the ratio of a width of an exhaust port 132 to a shortest distance between two said exhaust ports 132 is from 0.25 to 4.

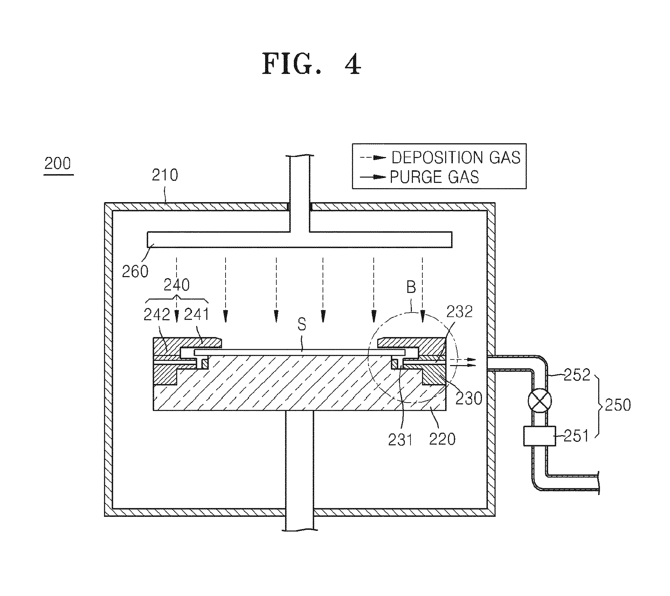

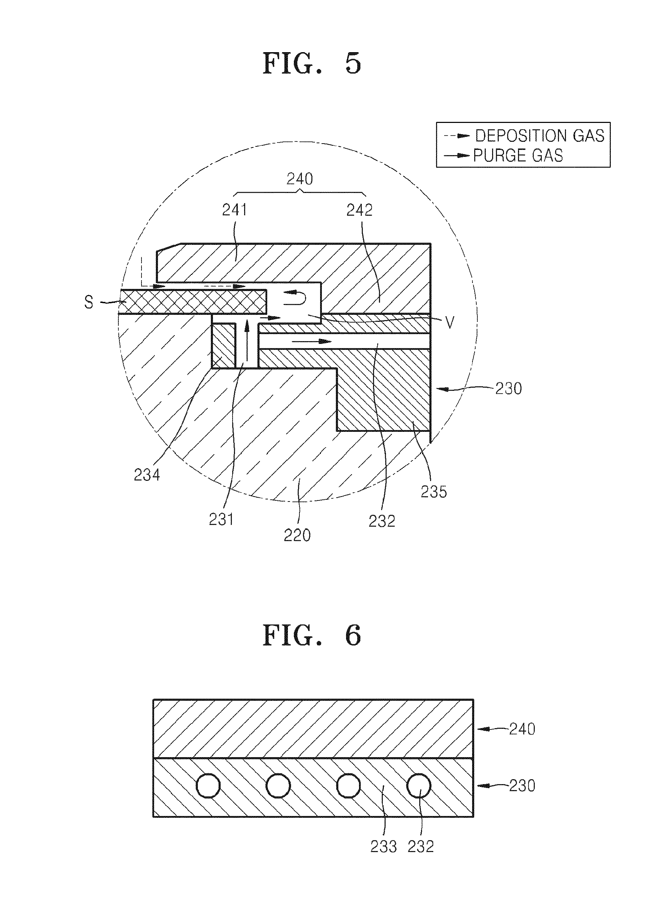

FIG. 4 is a conceptual diagram illustrating the chemical vapor deposition device 200 according to an exemplary embodiment of the present invention. FIG. 5 is an enlarged conceptual diagram illustrating a B portion of FIG. 4. FIG. 6 illustrates the side surface of the jacket and the shadow frame 240 illustrated in FIG. 5.

Referring to FIGS. 4 and 5, the chemical vapor deposition device 200 may include the support member 220, the jacket 230, the shadow frame 240 and the chamber 210. The support member 220, the jacket 230, the shadow frame 240, and the chamber 210 are similar to the support member 120, the jacket 130, the shadow frame 140, and the chamber 110 illustrated with reference to FIGS. 1 to 3, and thus the detailed description thereof will be omitted here.

Further, the chemical vapor deposition device 200 may include a suction unit 250 that is installed in the chamber 210, sucks the gas inside the chamber 210, and discharges the gas to the outside. The suction unit 250 may include a suction pipe 252 installed at the side surface of the chamber 210 and a vacuum pump 251 installed in the suction pipe 252.

The jacket 230 may include the exhaust unit 232, the support unit 233, the purge gas supply unit 234 and the jacket body unit 235 as illustrated above. The exhaust unit 232 may discharge a part of the purge gas, which is supplied from the purge gas supply hole 231 to the substrate S, to the suction unit 250 side. In particular, as described above, the exhaust unit 232 may be formed on the surface of the jacket 230 or may be formed in a hole shape inside the jacket 230. However, if the exhaust unit 232 is formed on the surface of the jacket 230, the exhaust unit 232 and the support unit 233 are similar to the description in FIGS. 1 to 3, and thus the detailed description thereof will be omitted here. Furthermore, for the convenience of explanation, the exhaust unit 232 will be described in detail centering on the case in which the exhaust unit 232 is formed in a hole shape inside the jacket 230.

The support unit 233 may be formed to be adjacent to the exhaust unit 232. The support unit 233 may be formed inside the jacket 230 that supports the shadow frame 240 by contacting the shadow frame 240.

Furthermore, the exhaust unit 232 may be formed inside the purge gas supply unit 234 and the jacket body unit 235 so as to be connected to the purge gas supply hole 231. The exhaust unit 232 may be formed between the support unit 233. Specifically, there may be a plurality of the exhaust units 232, and may be formed at regular intervals. The supporting member 233 may be formed between the exhaust units 232 so that the shape of the exhaust unit 232 is not deformed from the load or external force of the shadow frame 240.

Furthermore, the ratio of the width of the supporting unit 233 between adjacent exhaust units 232 to the diameter of the exhaust unit 232 may be between about 1:4 and about 4:1. The diameter of the exhaust unit 232 may be between about 20% and about 75% of the thickness of the jacket 230 as described above.

In another embodiment where the ratio of the exhaust unit 232 to the supporting unit 233 is 4:1 or 1:4, the ratio includes the diameter of the exhaust unit 232 in a first direction parallel to the substrate S, and the shortest distance between two adjacent exhaust units 232 where there are a plurality of exhaust units 232. For example, if the diameter of each exhaust unit 232 is 4, the shortest distance between two adjacent exhaust units 232 of the plurality of exhaust units 232 may be 1, and if the diameter of each exhaust unit 232 is 1, the shortest distance between two adjacent exhaust units 232 of the plurality of exhaust units 232 may be 4. In particular, in embodiments when the diameter of each exhaust unit 232 exceeds four times the shortest distance between two adjacent exhaust units 232 of the plurality of exhaust units 232, the supporting unit 233, which is located between adjacent exhaust units 232 of the plurality of exhaust units 232, may be deformed so that the supporting unit 233 fails to support the shadow frame 240, or the position of the shadow frame 240 deviates. In contrast, in embodiments where the diameter of each exhaust unit 232 is less than 1/4 the shortest distance between two adjacent exhaust units 232 of the plurality of exhaust units 232, the size of the exhaust unit 232 may be too small to smoothly exhaust the deposition gas or purge gas.

Furthermore, the operation of the chemical vapor deposition device 200 may be performed in a manner that is similar to that in the above description. Specifically, after the substrate S is placed on the support member 220, the support member 220 may be ascended or the shadow frame 240 may be descended, thereby fixing the substrate S at the support member 220.

When the process is completed, the deposition gas may be supplied to the upper surface of the substrate S through the shower head 260. The purge gas may be sprayed to the lower surface of the substrate S through the purge gas supply hole 231 as described above.

Likewise, if the deposition gas and the purge gas are supplied, the deposition gas may spread on the upper surface of the substrate S, and may deposit the substrate S. The deposition gas may flow into the border area of the substrate S as described above. The purge gas may prevent the lower surface of the substrate S from being deposited by blocking the deposition gas.

Furthermore, if the purge gas flows as described above, a problem may occur in the deposition uniformity of the border area of the substrate S as described above according to the flow of the purge gas. The part of the purge gas may be discharged to the outside of the jacket 230 through the exhaust unit 232. In particular, the purge gas may move to the suction unit 250 side through the exhaust unit 232.

Specifically, if the air inside the chamber 210 flows through the suction pipe 252 according to the operation of the vacuum pump 251, the purge gas may flow through the exhaust unit 232. In particular, as described above, the exhaust unit 232 may be formed to the suction pipe 252 side from the border of the substrate S so that the purge gas may flow to the outside of the jacket through the inside of the exhaust unit 232 according to the operation of the vacuum pump 251. As described above, if the purge gas flows, the purge gas may be prevented from excessively flowing to the border area of the substrate S.

Hence, the chemical vapor deposition device 200 may improve the deposition uniformity of the substrate S by preventing the purge gas from moving to the upper surface of the substrate S or being stored in the border area of the substrate S. Further, the chemical vapor deposition device 200 may promote a smooth discharge of the purge gas by discharging the purge gas to the side surface of the jacket 230.

In particular, the chemical vapor deposition device 200 exhausts a portion of the purge gas to the side of the jacket 230 before the purge gas is mixed with the deposition gas so as to prevent an excessive pressure from being formed on the border area of the substrate S due to the purge gas and the deposition gas. Further, if the pressure of the inside of the purge gas supply hole 231 is increased due to the purge gas, the purge gas is exhausted to the side through the exhaust unit 232, and thus the temporary vibration due to the high pressure or stoppage of the supply of the purge gas may be reduced. Furthermore, the chemical vapor deposition device 200 may exhaust the deposition gas and purge gas remaining on the border area of the substrate S to the outside through the exhaust unit 232 after the deposition process is completed, and thereby the purge gas may flow into a space between the substrate S and the shadow frame 240 or the deposition gas may flow into a space between the substrate S and the supporting unit 220 so as to prevent the damage to the deposition uniformity on the surface of the substrate S.

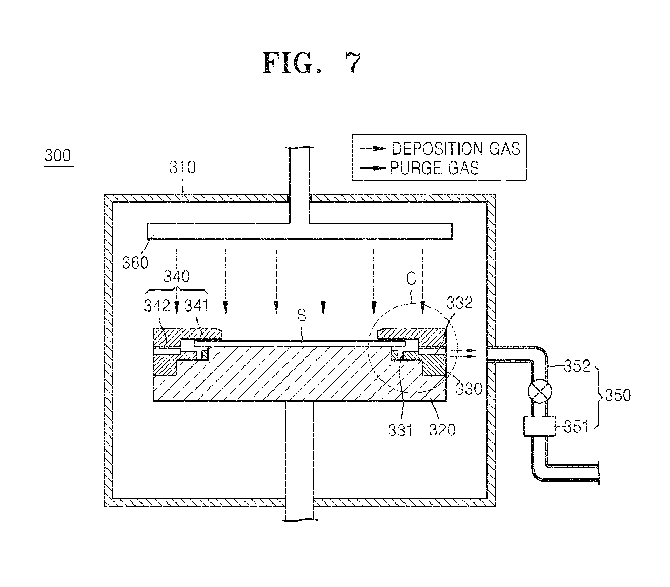

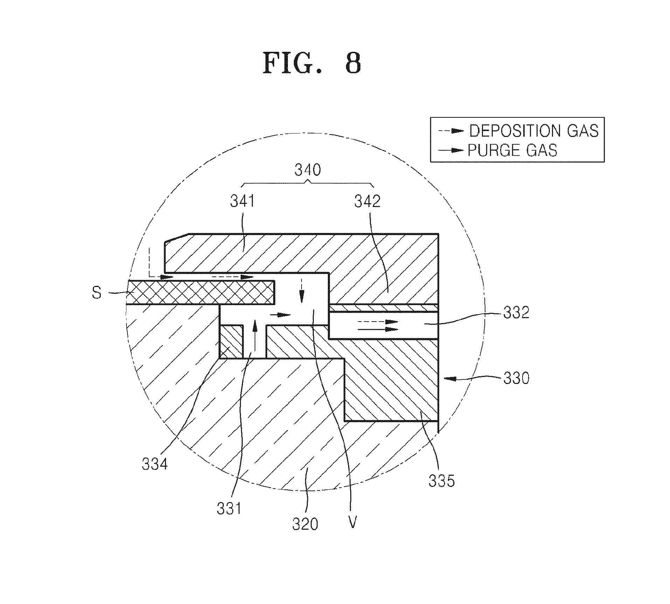

FIG. 7 is a conceptual diagram illustrating a chemical vapor deposition device 800 according to another exemplary embodiment of the present invention. FIG. 8 is an enlarged conceptual diagram of C portion of FIG. 7.

Referring to FIGS. 7 and 8, the chemical vapor deposition device 300 may include the support member 320, the jacket 330, the shadow frame 340 and the chamber 310. The support member 320, the jacket 330, the shadow frame 340, and the chamber 310 are similar to the support member 120, the jacket 130, the shadow frame 140, and the chamber 110 illustrated with reference to FIGS. 1 to 3, and thus the detailed description thereof will be omitted here.

Further, the chemical vapor deposition device 300 may include a suction unit 350 that is installed in the chamber 310, sucks the gas inside the chamber 310, and discharges the gas to the outside. The suction unit 350 may include a suction pipe 352 installed at the side surface of the chamber 310 and a vacuum pump 351 installed in the suction pipe 352. Here, the suction unit 350 is similar to the suction unit 250 described with reference to FIGS. 4 to 6, and thus the detailed description thereof is omitted here.

The jacket 330 may include the exhaust unit 332, the support unit (not shown), the purge gas supply unit 334 and the jacket body unit 335 as illustrated above. The exhaust unit 332 may discharge a part of the deposition gas and the purge gas stored in a space V formed by the border of the substrate S and the lower surface of the shadow frame 340, to the suction unit 350 side. In particular, as described above, the exhaust unit 332 may be formed on the surface of the jacket body unit 335 or may be formed in a hole shape inside the jacket body unit 335. However, if the exhaust unit 332 is formed on the surface of the jacket body unit 335, the exhaust unit 332 and the support unit are similar to the description in FIGS. 1 to 3, and thus the detailed description thereof will be omitted here. Furthermore, for the convenience of explanation, the exhaust unit 332 will be described in detail centering on the case in which the exhaust unit 332 is formed in a hole shape inside the jacket 330.

The support unit may be formed to be adjacent to the exhaust unit 332. The support unit may be formed inside the jacket 340 that supports the shadow frame 340 by contacting the shadow frame 340. Furthermore, the exhaust unit 332 may be formed to be connected to a space V formed by the upper surface of the purge gas supply unit 334, the border of the substrate S and the lower surface of the shadow frame 340. In particular, the exhaust unit 332 may be formed to be connected to at least one of the surface of the purge gas supply unit 334 and the surface of the jacket body unit 335 inside the space V formed by the upper surface of the purge gas supply unit 334, the border of the substrate S and the lower surface of the shadow frame 340.

The shape of the exhaust unit 332 may be a hole in which an entrance is formed on the surface of the purge gas supply unit 334 and an exit is formed to the external side of the jacket body unit 335. Further, the shape of the exhaust unit 332 may be a hole in which an entrance is formed on the side of the jacket body unit 335 and an exit is formed to the external side of the jacket body unit 335. In particular, the hole-shaped exhaust unit 332 may be formed in a straight line in a longitudinal direction of the jacket body unit 335 so that the deposition gas and the purge gas of the space V formed by the lower surface of the border and the shadow frame 340 is guided to the side of the jacket 330. Furthermore, there may be a plurality of the exhaust units 332, and may be formed at regular intervals. The supporting member may be formed between the exhaust units 332 so that the shape of the exhaust unit 332 is not deformed from the load or external force of the shadow frame 340.

Furthermore, the ratio of the width of the supporting unit (i.e. the distance between exhaust units 332) to the diameter of the exhaust unit 332 may be between about 1:4 and about 4:1. The diameter of the exhaust unit 332 may be between about 20% and about 75% of the thickness of the jacket 330 as described above.

Furthermore, the operation of the chemical vapor deposition device 300 may be performed in a manner that is similar to that in the above description. Specifically, after the substrate S is placed on the support member 320, the support member 320 may be ascended or the shadow frame 340 may be descended, thereby fixing the substrate S at the support member 320.

When the process is completed, the deposition gas may be supplied to the upper surface of the substrate S through the shower head 360. The purge gas may be sprayed to the lower surface of the substrate S through the purge gas supply hole 331 as described above.

Likewise, if the deposition gas and the purge gas are supplied, the deposition gas may spread on the upper surface of the substrate S, and may deposit the substrate S. The deposition gas may flow into the border area of the substrate S as described above. The purge gas may prevent the lower surface of the substrate S from being deposited by blocking the deposition gas.

Furthermore, if the purge gas flows as described above, a problem may occur in the deposition uniformity of the border area of the substrate S as described above according to the flow of the purge gas. The part of the purge gas and the deposition gas in the space V formed by the upper surface of the purge gas supply unit 334, the border of the substrate S and the shadow frame 340 may be discharged to the outside of the jacket 330 through the exhaust unit 332. In particular, the purge gas may move to the suction unit 350 side through the exhaust unit 332.

Specifically, if the air inside the chamber 310 flows through the suction pipe 352 according to the operation of the vacuum pump 351, the purge gas may flow through the exhaust unit 332. In particular, as described above, the exhaust unit 332 may be formed from the space V formed by the upper surface of the purge gas supply unit 334, the border of the substrate S and the shadow frame 340 to the suction pipe 352 side so that the purge gas may flow to the outside of the jacket through the inside of the exhaust unit 332 according to the operation of the vacuum pump 351. As described above, if the purge gas flows, the purge gas may be prevented from excessively flowing to the border area of the substrate S.

Hence, the chemical vapor deposition device 300 may improve the deposition uniformity of the substrate S by preventing the purge gas from moving to the upper surface of the substrate S or being stored in the border area of the substrate S. Further, the chemical vapor deposition device 300 may promote a smooth discharge of the purge gas by discharging the purge gas to the side surface of the jacket 330.

Furthermore, the chemical vapor deposition device 300 may exhaust purge gas remaining on the border area of the substrate S to the outside through the exhaust unit 332 after the deposition process is completed, and thereby the purge gas may flow into a space V between the substrate S and the shadow frame 340 so as to prevent the damage to the deposition uniformity on the surface of the substrate S.

As discussed above, embodiments of the invention provide a chemical vapor deposition device comprising: a support member arranged to support a first surface of a substrate; a deposition head arranged to supply deposition gas towards a second surface of the substrate, the second surface of the substrate being an opposite surface to the first surface of the substrate; a frame arranged around an edge portion of the support member, the frame having a purge gas supply port arranged to supply purge gas from a location on a side of the substrate opposite to the deposition head, and at least one exhaust port arranged around an edge portion of the support member; and a chamber arranged to house the support member, deposition head, and the frame.

In some embodiments, a dimension of the exhaust port (e.g. the largest dimension, e.g. the diameter if circular) is from between 20% to 75% of a thickness of the frame.

In some embodiments, the frame comprises a plurality exhaust, and the ratio of a width of an exhaust port to a shortest distance between two exhaust ports from 0.25 to 4.

Though the present invention has been described with reference to the above mentioned exemplary embodiments, but the present invention may be modified in various ways within the scope of the invention. Therefore, the attached claims may include such modifications within the scope of the present invention.

## Claims

1. A chemical vapor deposition device (100, 200, 300) comprising:
a support member (120, 220, 320) arranged to support a first surface of a substrate;
a deposition head (160, 260, 360) arranged to supply deposition gas towards a second surface of the substrate, the second surface of the substrate being an opposite surface to the first surface of the substrate;
a frame arranged around an edge portion of the support member (120, 220, 320), the frame having a purge gas supply port (131, 231, 331) arranged to supply purge gas from a location on a side of the substrate opposite to the deposition head (160, 260, 360), and at least one exhaust port (132, 232, 332) arranged around an edge portion of the support member (120, 220, 320); and
a chamber (110, 210, 310) arranged to house the support member (120, 220, 320), deposition head (160, 260, 360), and the frame.

2. A chemical vapor deposition device (100, 200, 300) according to claim 1, wherein the frame comprises a jacket (130, 230, 330) arranged around the edge portion of the support member (120, 220, 320).

3. A chemical vapor deposition device (100, 200, 300) according to claim 2, wherein the jacket (130, 230, 330) is arranged to cover a portion of the first surface of the substrate.

4. A chemical vapor deposition device (100, 200, 300) according to claim 2 or 3, wherein the frame comprises a shadow frame (140, 240, 340) arranged around an edge portion of the support member (120, 220, 320) so as to cover a portion of the second surface of the substrate.

5. A chemical vapor deposition device (100, 200, 300) according to claim 4, wherein a portion of the jacket (130, 230, 330) is arranged to support the shadow frame (140, 240, 340).

6. A chemical vapor deposition device (100, 200, 300) according to claim 4 or 5, wherein the deposition gas is arranged to flow from the deposition head (160, 260, 360) to the second surface of substrate; and
wherein the purge gas is arranged to flow towards the deposition head, and then towards a said exhaust port (133, 232, 332).

7. A chemical vapor deposition device (100, 200, 300) according to claim 6, wherein the purge gas is arranged to flow from the purge gas supply port (131, 231, 331) to the first surface of the substrate, between the first surface of the substrate and a portion of the jacket (130, 230, 330), and then towards a said exhaust port (132, 232, 332).

8. A chemical vapor deposition device (100, 200, 300) according to any one of claims 2 to 7, wherein the jacket (130, 230, 330) comprises the each exhaust port (132, 232, 332).

9. A chemical vapor deposition device (100, 200, 300) according to any one of claims 2 to 8, wherein the purge gas supply port (131, 231, 331) comprises a hole extending though a portion of the jacket (130, 230, 330).

10. A chemical vapor deposition device (200) according to claim 9, wherein at least one said exhaust port (232) is formed as a hole extending from a portion of the hole forming the purge gas supply port (231) to an external portion of the jacket (230).

11. A chemical vapor deposition device (100) according to any one of claims 4 to 9, wherein the each exhaust port (132) is located between the jacket (130) and the shadow frame (140).

12. A chemical vapor deposition device (100, 200, 300) according to any one of claims 2 to 11, wherein the jacket (130, 230, 330) comprises a purge gas supply unit (134, 234, 334) coupled with the purge gas supply port (131, 231, 331); and a jacket body (135, 235, 335) coupled to the purge gas supply unit (134, 234, 334).

13. A chemical vapor deposition device (200, 300) according to any one of claims 1 to 12, further comprising an exhaust unit (250, 350) coupled to the chamber (210, 310), wherein the exhaust unit (250, 350) is arranged to remove exhaust deposition gas and exhaust purge gas from the chamber (210, 310).

14. A chemical vapor deposition device (200, 300) according to claim 13, wherein the exhaust unit (250, 350) is located proximate a said exhaust port (132, 232, 332).

15. A chemical vapor deposition device (200, 300) according to claim 13 or 14, wherein the exhaust unit (250, 350) comprises: a suction pipe (252, 352) coupled to the chamber (210, 310); and a vacuum pump (251, 351) coupled to the suction pipe (252).

16. A chemical vapor deposition device (100, 200, 300) according to any one of claims 1 to 15, wherein a dimension of the exhaust port (132, 232, 332) is from between 20% to 75% of a thickness of the frame.

17. A chemical vapor deposition device (100, 200, 300) according to any one of claims 1 to 16, wherein the frame comprises a plurality of exhaust ports (132, 232, 332), and wherein the ratio of a width of a said exhaust port (132, 232, 332) to a shortest distance between two said exhaust ports (132, 232, 332) is from 0.25 to 4.
